# EUROPEAN PATENT APPLICATION

(11) **EP 1 662 580 A1**
(43) Date of publication of application: **31.05.2006**
(21) Application number: 04820880.5
(22) Date of filing: 30.11.2004
(51) Int. Cl.: H01L 31/0336, H01L 31/072

(54) **COMPOUND SEMICONDUCTOR FILM, SOLAR CELL, AND METHODS FOR PRODUCING THOSE**

(30) Priority: 05.12.2003 JP 2003407776
(71) Applicant: MATSUSHITA ELECTRIC INDUSTRIAL CO., LTD., Kadoma-shi, Osaka 571-8501 (JP)
(72) Inventor: HASHIMOTO, Yasuhiro, Nara 630-025 (JP); SATOH, Takuya, Kyoto 614-8297 (JP); NEGAMI, Takayuki, Osaka 573-0164 (JP)
(74) Representative: Tothill, John Paul
(86) International application number: PCT/JP2004/017756
(87) International publication number: WO 2005/064692

(57) **Abstract**

A compound semiconductor film is formed with a compound containing: A. at least one element selected from zinc, tin, cadmium, indium, and gallium; B. at least one element selected from oxygen and sulfur; and C. an element of Group IIa. A solar cell is configured to include: a substrate (11); a conductive layer (12) formed on the substrate (11); a light-absorption layer (13) that is formed on the conductive layer (12) with a compound semiconductor containing an element of Group Ib, an element of Group IIIa, and an element of Group VIa; the above-described compound semiconductor film (14) formed on the light-absorption layer (13); and a transparent conductive layer (16) formed on the compound semiconductor film (14). Such a configuration provides a compound semiconductor film having a low electric resistivity. Further by employing the compound semiconductor film having a low electric resistivity as a buffer layer of a solar cell, the energy conversion efficiency of the solar cell is improved.

## Description

### Technical Field

The present invention relates to a compound semiconductor film, particularly zinc-based, tin-based, cadmium-based, indium-based, or gallium-based compound semiconductor film. The present invention also relates to a solar cell, particularly a solar cell provided with a light-absorption layer formed with a compound semiconductor containing an element of Group Ib, an element of Group IIIb, and an element of Group VIb.

### Background Art

A thin film solar cell using CuInSe₂ (hereinafter referred to as CIS) or Cu(In, Ga)Se₂ (hereinafter referred to as CIGS) as a light-absorption layer has an advantage of showing a high energy conversion efficiency and being free from a deterioration in the energy conversion efficiency caused by the irradiation with light or the like, where the CuInSe₂ is a compound semiconductor (chalcopyrite structured compound semiconductor) containing an element of Group Ib, an element of Group IIIB and an element of Group VIB, while the Cu(In, Ga)Se₂ is a solid solution of CIS with Ga.

A conventional CIS solar cell is formed by chemical deposition of an n-type semiconductor layer on a CIS film, and likewise a conventional CIGS solar cell is formed by chemical deposition of an n-type semiconductor layer on a CIGS film.

A conventional typical solar cell provided with a CIS film or CIGS film as a light-absorption layer includes a substrate, a back-side electrode stacked on the substrate, a p-type light-absorption layer, a buffer layer, a window layer, a transparent conductive layer, and a p-side electrode in contact with the back-side electrode, and an n-side electrode in contact with the transparent conductive layer.

In a conventional solar cell, a CdS film mainly has been used as the buffer layer. However, since Cd is toxic, a buffer layer not containing Cd has been demanded. For this purpose, a Zn-based buffer layer formed by employing a Zn-based compound semiconductor film has been developed (for instance, see the following non-patent document 1).
Non-patent document 1: Jpn. Appl. Phys. Vol. 35 (1996) pp. 4383 - 4388, Hitoshi KUSHIYA, "Application of Zn-Compound Buffer Layer for Polycrystalline CuInSe₂-Based Thin Film Solar Cells)

However, since the conventional non-Cd-based buffer layer formed by employing the non-Cd-based compound semiconductor film has an extremely high electric resistance, there has been a problem that the solar cell provided with the non-Cd-based buffer layer has a low energy conversion efficiency.

### Disclosure of Invention

To solve the above-described problem of the prior art, it is an object of the present invention to provide a compound semiconductor film with a low electric resistivity, a solar cell, and methods for producing the same.

A compound semiconductor film of the present invention contains:
A. at least one element selected from the group consisting of zinc, tin, cadmium, indium, and gallium;
B. at least one element selected from oxygen and sulfur; and
C. an element of Group IIa.

A method of the present invention for producing a compound semiconductor film includes the steps of:
preparing a material solution by dissolving in water a compound containing at least one selected from zinc, tin, cadmium, indium, and gallium, a compound containing sulfur, and a Group IIa element compound containing an element of Group IIa; and
bringing the material solution prepared at a predetermined temperature into contact with a substrate so that a compound semiconductor film is deposited on the substrate, the compound semiconductor film containing:
   A. at least one element selected from zinc, tin, cadmium, indium, and gallium;
   B. at least one element selected from oxygen and sulfur; and
   C. an element of Group IIa.

A solar cell of the present invention is a solar cell obtained by either stacking a substrate, a conductive film, a light-absorption layer, a compound semiconductor film, and a transparent conductive layer in the stated order, or stacking a substrate, a conductive film, a compound semiconductor film, a light-absorption layer, and a transparent conductive layer in the stated order,
wherein the compound semiconductor film contains:
A. at least one element selected from zinc, tin, cadmium, indium, and gallium;
B. at least one element selected from oxygen and sulfur; and
C. an element of Group IIa.

A method of the present invention for producing a solar cell includes the step of either:
stacking a substrate, a conductive film, a light-absorption layer, a compound semiconductor film, and a transparent conductive layer in the stated order; or
stacking a substrate, a conductive film, a compound semiconductor film, a light-absorption layer, and a transparent conductive layer in the stated order,
wherein the compound semiconductor film is formed by:
   preparing a material solution by dissolving in water a compound containing at least one selected from the group consisting of zinc, tin, cadmium, indium, and gallium, and a compound containing sulfur, and a Group IIa element compound containing an element of Group IIa; and
   bringing the material solution prepared at a predetermined temperature into contact with at least the substrate so that a compound semiconductor film is deposited, the compound semiconductor film containing:
      A. at least one element selected from zinc, tin, cadmium, indium, and gallium;
      B. at least one element selected from oxygen and sulfur; and
      C. an element of Group IIa.

### Brief Description of Drawings

[FIG. 1] FIG. 1 is a cross-sectional view illustrating a configuration of a solar cell according to an example of the present invention.
[FIG. 2] FIG. 2 is a graph showing volume resistivities of compound semiconductor films according to Example 3 of the present invention.
[FIG. 3] FIG. 3 is a graph showing energy conversion efficiencies of solar cells according to Example 3 of the present invention.

### Description of the Invention

A compound semiconductor film according to the present invention contains at least one element selected from zinc, tin, cadmium, indium, and gallium, at least one element selected from oxygen and sulfur, and an element of Group IIa. In the present specification, each group is called by the name according to the short-form periodic table. It should be noted that "Group IIa" refers to the "Group 2" according to the long-form periodic table recommended by the International Union of Pure and Applied Chemistry (IUPAC).

A solar cell according to the present invention includes a conductive layer; a transparent conductive layer; a light-absorption layer that is provided between the conductive layer and the transparent conductive layer, and that is made of a compound semiconductor containing an element of Group Ib, an element of Group IIIb, and an element of Group VIb; and a compound semiconductor film that is provided between the light-absorption layer and the transparent conductive layer, and that contains at least one element selected from zinc, tin, cadmium, indium, and gallium, at least one element selected from oxygen and sulfur, and an element of Group IIa. It should be noted that "Group Ib", "Group IIIb", and "Group VIb" refer to "Group 11", "Group 13", and "Group 16" according to the long-form periodic table recommended by the IUPAC, respectively. The solar cell of the present invention may be a solar cell of the substrate type or a solar cell of the superstrate type.

More specifically, the substrate-type solar cell according to the present invention includes: a substrate; a conductive layer formed on the substrate; a light-absorption layer that is formed on the conductive layer and that is made of a compound semiconductor containing an element of Group Ib, an element of Group IIIb, and an element of Group VIb; a compound semiconductor film that is formed on the light-absorption layer and that contains at least one element selected from zinc, tin, cadmium, indium, and gallium, at least one element selected from oxygen and sulfur, and an element of Group IIa; and a transparent conductive layer formed on the compound semiconductor film.

The superstrate-type solar cell according to the present invention includes: a substrate: a transparent conductive layer formed on the substrate; a compound semiconductor film that is formed on the transparent conductive layer and that contains at least one element selected from zinc, tin, cadmium, indium, and gallium, at least one element selected from oxygen and sulfur, and an element of Group IIa; a light-absorption layer that is formed on the compound semiconductor film and that is made of a compound semiconductor containing an element of Group Ib, an element of Group IIIb, and an element of Group VIb; and a conductive layer formed on the light-absorption layer.

According to the present invention, an element of Group IIa is doped in the compound semiconductor film, whereby an electric resistance of the compound semiconductor film can be reduced. Further, according to the present invention, the compound semiconductor film with a reduced electric resistance is used as a buffer layer, whereby an energy conversion efficiency of the solar cell can be improved.

The compound semiconductor film of the present invention contains at least one selected from Zn, Sn, Cd, In, and Ga, at least one selected from O and S, and an element of Group IIa, as described above. The compound semiconductor film of the present invention may be configured so that, regarding the element of Group IIa contained therein, one element of Group IIa may be contained, or a plurality of different elements of Group IIa may be contained. The elements of Group IIa to be contained in the compound semiconductor film preferably are Mg, Ca, Sr, and Ba. By adding such elements, an electric resistance of the compound semiconductor film can be reduced excellently.

The method for producing the compound semiconductor film of the present invention, as described above, is a method that employs a material solution (aqueous solution) obtained by dissolving in water a compound containing at least one element selected from zinc, tin, cadmium, indium, and gallium, a sulfur containing compound that contains sulfur, and a Group IIa element compound that contains an element of Group IIa, so that a compound semiconductor film is grown in the liquid phase on a substrate. By this producing method, a compound semiconductor film containing at least one selected from Zn, Sn, Cd, In, and Ga, at least one selected from O and S, and an element of Group IIa can be produced. The material solution may be a solution in which ammonia, an ammonium salt, etc., is dissolved additionally

As the Group IIa element compound, for instance, any one selected from the following is dissolved in the material solution: one compound containing one element of Group IIa; a plurality of compounds each of which contains the same one element of Group IIa; one compound containing a plurality of elements of Group IIa; and a plurality of compounds containing a plurality of elements of Group IIa. Further, as the compound containing at least one element selected from zinc, tin, cadmium, indium, and gallium, for example, any one selected from the following is dissolved in the material solution: one compound containing at least one element selected from zinc, tin, cadmium, indium, and gallium; and a plurality of compounds each of which contains at least one element selected from zinc, tin, cadmium, indium, and gallium. Still further, as the sulfur containing compound, for instance, either one compound containing sulfur, or a plurality of compounds each of which contains sulfur, are dissolved in the material solution.

In the method of the present invention for producing a compound semiconductor film, as the Group IIa element compound, the following can be used: a chloride of an element of Group IIa; an iodide of an element of Group IIa; a bromide of an element of Group IIa; a nitrate of an element of Group IIa; a sulfate of an element of Group IIa; or an acetate of an element of Group IIa.

In the method of the present invention for producing a compound semiconductor film, the material solution preferably has a pH in a range of not less than 9 and not more than 11 in the step in which a compound is deposited. In the case where the pH of the material solution is in the foregoing range, a compound semiconductor film with high quality can be produced. It should be noted that the pH of the material solution varies with the temperature of the material solution.

The pH of the material solution can be adjusted by, for instance, dissolving ammonia and/or an ammonium salt in the material solution. Further, by dissolving ammonia and/or an ammonium salt in the material solution, Zn, Cd, etc. is caused to form a complex. Zn, Cd, etc. is stabilized by forming a complex, whereby the film formation reaction proceeds slowly. Consequently a dense and high-quality compound can be formed.
Accordingly, in the step of preparing the material solution, the pH of the material solution preferably is adjusted by dissolving ammonia additionally in water. This is because by using the material solution in which ammonia is dissolved, the compound semiconductor film of the present invention can be produced efficiently. Further, in the step of preparing the material solution, the pH of the material solution preferably is adjusted by dissolving an ammonium salt additionally in water. This is because by using the material solution in which ammonia and an ammonium salt are dissolved, the compound semiconductor film of the present invention can be produced efficiently without a groundwork layer (substrate) of the compound semiconductor film being damaged. In the method of the present invention for producing a compound semiconductor film, as the ammonium salt, for instance, at least one compound selected from the group consisting of ammonium acetate, ammonium chloride, ammonium iodide, and ammonium sulfate can be used.

In the method of the present invention for producing a compound semiconductor film, the predetermined temperature of the material solution in the step in which a compound is deposited is preferably in a range of not lower than 10°C and not higher than 100°C. This is because in the case where the temperature of the material solution is in the foregoing range, a high-quality compound semiconductor film can be produced.

When the material solution and the substrate are brought into contact with each other, the material solution may be applied over a surface of the substrate, or alternatively, only a part of the substrate including a part of a surface of the substrate may be brought into contact with the material solution, or further alternatively, the substrate may be immersed in the material solution. In the method of the present invention for producing a compound semiconductor film, the substrate preferably is immersed in the material solution in the step of depositing a compound. This is because a homogeneous compound semiconductor film can be produced by using the immersion method, and further, a film thickness of the compound semiconductor film can be controlled simply by controlling the immersion time.

In the method of the present invention for producing a compound semiconductor film, in the step of preparing the material solution, at least one compound selected from the group consisting of acetates, chlorides, iodides, and sulfates can be dissolved as the compound in water.

In the method of the present invention for producing a compound semiconductor film, at least one compound selected from the group consisting of thiourea and thioacetamide can be dissolved as a compound containing sulfur in water in the step of preparing the material solution.

The solar cell of the present invention is, as described above, configured so that the compound semiconductor film of the present invention is provided between a light-absorption layer and a transparent conductive layer. It should be noted that the compound semiconductor film of the present invention functions as a buffer layer in the solar cell. This configuration reduces an electric resistance of the buffer layer, whereby the energy conversion efficiency can be improved.

The solar cell of the present invention is, as described above, configured so that the compound semiconductor film of the present invention is provided as a buffer layer. The compound semiconductor film of the present invention has a small electric resistance as compared with a conventional compound semiconductor film that does not contain an element of Group IIa. Therefore, the energy conversion efficiency of the solar cell can be improved.

The solar cell of the present invention preferably is configured so that the element of Group IIa used therein is magnesium, calcium, strontium, or barium.

Further, the general formula of the compound semiconductor film of the present invention preferably is MIIaₓ(O, S) or MIIaₓ(O, OH, S) (where M represents at least one element selected from zinc, tin, cadmium, indium, and gallium, and x represents a value in a range of 0.0008 to 0.012). In the case where the content of the element of Group IIa is in the foregoing range, the compound semiconductor film functions excellently as a buffer layer of the solar cell.

The solar cell of the present invention can be configured so that a compound semiconductor in the light-absorption layer contains Cu as an element of Group Ib, at least one element selected from the group consisting of In and Ga as an element of Group IIIb, and at least one element selected from the group consisting of Se and S as an element of Group VIb.

In the method of the present invention for producing a solar cell, as described above, the method of the present invention for producing a compound semiconductor film is used for forming the compound semiconductor film that functions as a buffer layer. It should be noted that in the production of the solar cell of the present invention, any known technologies may be used for steps other than the step of forming a compound semiconductor film.

According to the method of the present invention for producing a solar cell, a compound semiconductor film having a desired electric resistance can be formed by controlling the content of an element of Group IIa in the compound semiconductor film and the thickness of the compound semiconductor film. The content of an element of Group IIa in the compound semiconductor film can be controlled by controlling the concentration of the Group IIa element compound dissolved in the material solution and the temperature of the material solution in the deposition of the compound.

### Example 1

The following describes, as Example 1, a case where a substrate having a CuInSe₂ thin film on its surface and a material solution are brought into contact with each other so that a Zn-based compound semiconductor film is formed on the CuInSe₂ thin film of the substrate.

First, a Mo film was formed by sputtering on a glass substrate. Thereafter, a CuInSe₂ thin film was formed on the Mo film. With this, the preparation of the substrate was completed.

Next, a material solution for forming a Zn-based compound semiconductor film was prepared by dissolving zinc chloride (ZnCl₂) as a Zn compound (salt) containing zinc, thiourea (NH₂CSNH₂) as a compound containing sulfur, calcium chloride (CaCl₂) as a Group IIa element compound containing Ca, and ammonium chloride (NH₄Cl) in water. The material solution was prepared so that the concentration of zinc chloride was 0.01 mol/L, the concentration of thiourea was 0.2 mol/L, the concentration of calcium chloride was 0.0001 mol/L, and the concentration of ammonium chloride was 0.5 mol/L. After preparing the material solution, a container containing the material solution was left to stand in a hot water vessel whose temperature was kept at 85°C, so that the temperature of the material solution was adjusted to 85°C. After the temperature of the material solution was stabilized, the substrate having a CuInSe₂ thin film was immersed in the material solution for about 20 minutes. Thereafter, the substrate was removed out of the material solution, and subsequently was washed with pure water. Through this process, a Zn-based compound semiconductor film was obtained.

The composition of the Zn-based compound semiconductor film of the present Example 1 was analyzed by X-ray photoelectron spectroscopy. In this analysis, Zn, O, and S were detected in the Zn-based compound semiconductor film. Further, by determining a bond energy of O on the 1s orbit, it was clarified that O in the Zn-based compound semiconductor film was present in two states, i.e., a state of O alone, and a state of OH. Further, analysis by an inductively coupled plasma (ICP) spectrometry device showed that Ca was contained in the Zn-based compound semiconductor film. The concentrations of the elements were as follows: the concentration of Zn was 46.24 atom%, the concentration of O was 37.8 atom%, the concentration of S was 11.1 atom%, the concentration of H was 4.4 atom%, and the concentration of Ca was approximately 0.46 atom%.

According to the foregoing producing method, a Zn(O, OH, S):Ca film was formed easily on the CuInSe₂ thin film of the substrate.

The obtained compound semiconductor film had a volume resistivity (Ω·cm) of 2x109.

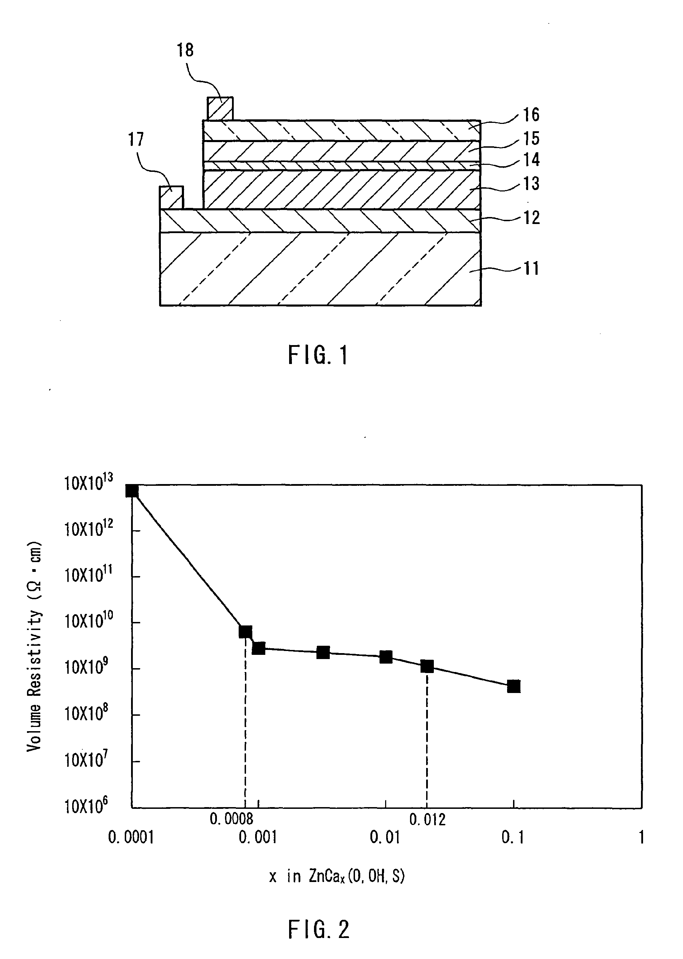

Next, an example of a solar cell provided with the foregoing Zn-based compound semiconductor film as a buffer layer is described in the following, with reference to FIG. 1.

The solar cell shown in FIG. 1 is a substrate-type solar cell that includes: a glass substrate 11 (substrate); a Mo film 12 (conductive layer) formed on the glass substrate 11; a Cu(In, Ga)Se₂ film 13 (light-absorption layer) formed on a surface of a part of the Mo film 12; a p-side lead electrode 17 formed on a surface of another part of the Mo film 12; a Zn(O, OH, S):Ca film 14 (Zn-based compound semiconductor film) formed on the Cu(In, Ga)Se₂ film 13; a ZnO film 15 (window layer) formed on the Zn(O, OH, S):Ca film 14; an indium-tin oxide alloy (ITO) film 16 (transparent conductive layer) formed on the ZnO film 15; and a n-side lead electrode 18 formed on a surface of a part of the ITO film 16.

The solar cell shown in FIG. 1 was produced through the following process. First, the glass substrate 11 was prepared. Next, the Mo film 12 (film thickness: 1 µm) was formed by sputtering as a conductive layer (backside electrode) over an entirety of the glass substrate 11. Then, the Cu(In, Ga)Se₂ film 13 (film thickness: 2 µm) was formed by vapor deposition over an entirety of the Mo film 12.

Next, the Zn(O, OH, S):Ca film 14 (film thickness: 100 nm) was formed by the same method as above over an entirety of the Cu(In, Ga)Se₂ film 13. Subsequently, the ZnO film 15 (film thickness: 100 nm) was formed by sputtering over an entirety of the Zn(O, OH, S):Ca film 14. Then, the ITO film 16 (film thickness: 100 nm) was formed by sputtering over an entirety of the ZnO film 15. The sputtering for forming the ZnO film 15 and the ITO film 16 was carried out in an argon gas atmosphere at a gas pressure of 1.07 Pa (8×10⁻³ Torr), with a high-frequency power of 500 W being applied to a target. Then, after the ITO film 16 was formed, a part of the Mo film 12 was exposed by mechanically removing the Cu(In, Ga)Se₂ film by taking an advantage of the hardness difference between Mo and Cu(In, Ga)Se₂. Next, a mask on which an electrode pattern was drawn was attached so as to cover the surface of the ITO film 16 and the exposed surface of the Mo film 12, and a NiCr film was formed by electron beam evaporation, and successively an Au film was formed by electron beam evaporation over an entirety of the NiCr film, so that the p-side lead electrode 17 (film thickness: 350 nm) and the n-side electrode 18 (film thickness: 350 nm) were formed. As a result, the solar cell shown in FIG. 1 was completed.

A pseudo-solar light beam with an AM (Air Mass) of 1.5 and an intensity of 100mW/cm² was projected onto the solar cell shown in FIG. 1, and solar cell properties were assessed. Consequently, the solar cell exhibited an open circuit voltage of 0.64 V, a short circuit current of 34.2 mA/cm², a fill factor of 0.65, and an energy conversion efficiency of 14.2 %.

### (Comparative Example 1)

For comparison with Example 1, a solar cell as Comparative Example was produced by the same method as that for producing the solar cell shown in FIG. 1 except that a Zn(O, OH, S) film was formed instead of the Zn(O, OH, S):Ca film 14 in Example 1. It should be noted that the Zn(O, OH, S) film was formed by the same method as that for forming the Zn(O, OH, S):Ca film 14 except that calcium chloride was not dissolved in the material solution.

Regarding the solar cell of Comparative Example also, solar cell properties were assessed by the same method as that for assessing the solar cell shown in FIG. 1. Consequently, the solar cell of Comparative Example exhibited an open circuit voltage of 0.26 V, a short circuit current of 12.0 mA/cm², a fill factor of 0.23, and an energy conversion efficiency of 0.7 %.

The solar cell properties of the solar cell of Comparative Example were inferior to those of the solar cell shown in FIG. 1. This inferiority is due to a high volume resistivity of the Zn(O, OH, S) film.

### Example 2

The following describes, as Example 2, a case where a substrate having a Cu(In, Ga)Se₂ thin film on its surface and a material solution are brought into contact with each other so that a Zn-based compound semiconductor film is formed on the Cu(In, Ga)Se₂ thin film of the substrate.

First, a Mo film was formed by sputtering on a glass substrate. Thereafter, a Cu(In, Ga)Se₂ thin film was formed on the Mo film. With this, the preparation of the substrate was completed.

Next, a material solution was prepared by dissolving zinc acetate (Zn(CH₃COO)₂) as a Zn compound (salt) containing zinc, thiourea (NH₂CSNH₂) as a S compound containing sulfur, barium chloride (BaCl₂) as a Group IIa element compound containing Ba, ammonia (NH₃), and ammonium acetate (CH₃COONH₄) in water. The material solution was prepared so that the concentration of zinc acetate was 0.01 mol/L, the concentration of thiourea was 0.2 mol/L, the concentration of barium chloride was 0.0001 mol/L, the concentration of ammonia was 0.5 mol/L, and the concentration of ammonium acetate was 0.1 mol/L. After preparing the material solution, a container containing the material solution was left to stand in a hot water vessel whose temperature was kept at 85°C, so that the temperature of the material solution was adjusted to 85°C. After the temperature of the material solution was stabilized, the substrate having a Cu(In, Ga)Se2 thin film was immersed in the material solution for about 20 minutes. Thereafter, the substrate was removed out of the material solution, and subsequently was washed with pure water. Through this process, the formation of a Zn-based compound semiconductor film was completed.

The composition of the Zn-based compound semiconductor film of the present Example 2 was analyzed by X-ray photoelectron spectroscopy. In this analysis, Zn, O, and S were detected in the Zn-based compound semiconductor film. Further, by determining a bond energy of O on the 1s orbit, it was clarified that O in the Zn-based compound semiconductor film was present in two states, i.e., a state of O alone, and a state of OH. Further, analysis by an inductively coupled plasma (ICP) spectrometry device showed that Ba was contained in the Zn-based compound semiconductor film. The concentrations of the elements were as follows: the concentration of Zn was 46.24 atom%, the concentration of O was 37.8 atom%, the concentration of S was 11.1 atom%, the concentration of H was 4.4 atom%, and the concentration of Ba was 0.46 atom%. In other words, Ba accounted for 0.01 atom% per one atom of Zn.

According to the foregoing producing method, a Zn(O, OH, S):Ba film was formed easily on the Cu(In, Ga)Se₂ thin film.

The obtained compound semiconductor film had a volume resistivity (Ω·cm) of 2×109.

Next, a solar cell was formed in the same manner as that of Example 1. A pseudo-solar light beam with an AM (Air Mass) of 1.5 and an intensity of 100mW/cm² was projected to the solar cell, and solar cell properties were assessed. Consequently, the open circuit voltage was 0.65 V, the short circuit current was 34.5 mA/cm², the fill factor was 0.66, and the energy conversion efficiency was 14.8 %.

As Examples 1 and 2, examples in which Zn(O, OH, S)ₓ:Group IIa element was used were described, but the same effect can be achieved by using Zn(O, S)ₓ:Group IIa element, Sn(O, OH, S)ₓ:Group IIa element, Cd(O, OH, S)ₓ:Group IIa element, CdZn(O, OH, S)ₓ:Group IIa element, ZnSn (O, OH, S)ₓ:Group IIa element, In(O, OH, S)ₓ:Group IIa element, Ga(O, OH, S)ₓ:Group IIa element, InGa(O, OH, S)ₓ:Group IIa element, ZnGa(O, OH, S)ₓ:Group IIa element, Znln(O, OH, S)ₓ:Group IIa element, CdS:Group IIa element, ZnS:Group IIa element, In₂S₃:Group IIa element, Ga₂S₃:Group IIa element, In₂O₃:Group IIa element, or Ga₂O₃:Group IIa element.

### Example 3

Experiments were carried out in the same manner as the foregoing examples except that an amount of calcium chloride (CaCl₂) added was varied and the value of x of ZnCaₓ(O, OH, S) was set as shown in Table 1 below. Values regarding compound semiconductor films and solar cells detected as a result of the experiments are shown in Table 1.

Table 1

| Experiment No. | Value of x of ZnCaₓ(O, OH, S) (atomic ratio) | Volume Resistivity (Ω·cm) | Open Circuit Voltage (V) | Short Circuit Current (mA/cm²) | Fill Factor | Energy Conversion Efficiency (%) |
|---|---|---|---|---|---|---|
| 1 | - | 1 × 10¹³ | 0.26 | 8.5 | 0.23 | 0.5 |
| 2 | 0.0001 | 1 × 10¹³ | 0.26 | 12.0 | 0.33 | 1.0 |
| 3 | 0.0008 | 8 × 10⁹ | 0.63 | 32.8 | 0.63 | 13.0 |
| 4 | 0.001 | 8 × 10⁹ | 0.63 | 33.1 | 0.63 | 13.1 |
| 5 | 0.005 | 4 × 10⁹ | 0.63 | 33.6 | 0.64 | 13.5 |
| 6 | 0.01 | 2 × 10⁹ | 0.64 | 34.2 | 0.65 | 14.2 |
| 7 | 0.012 | 2 × 10⁹ | 0.64 | 34.1 | 0.65 | 14.2 |
| 8 | 0.1 | 4 × 10⁸ | 0.45 | 26.0 | 0.43 | 5.0 |

As is clear from Table 1, the compound semiconductor films and the solar cells of the present example exhibited excellent outcomes.

The detected volume resistivities of the compound semiconductor films of Example 3 are shown in the graph of FIG. 2. The graph shows that, particularly preferably, the value of x of ZnCaₓ(O, OH, S) is in a range of 0.0008 to 0.012 (atomic ratio).

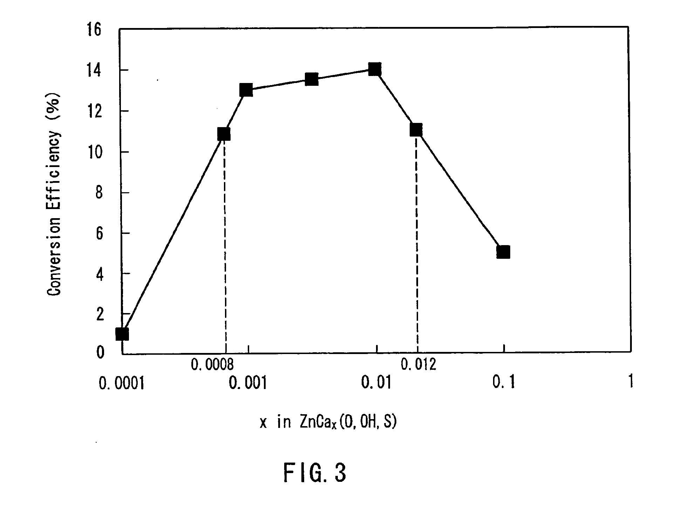

FIG. 3 is a graph of energy conversion efficiencies (%) of solar cells of Example 3. The graph shows that the value of x of ZnCaₓ(O, OH, S) is particularly preferably in a range of 0.0008 to 0.012 (atomic ratio).

### Example 4

Experiments were carried out in the same manner as Example 1 except that magnesium chloride (MgCl₂) or strontium chloride (SrCl₂) was used in place of calcium chloride (CaCl₂). Values regarding compound semiconductor films and solar cells detected as a result of the experiments are shown in Table 2. Here, in the row of "the added amount of the Group IIa element compound (atomic ratio)", general formulae of the compound semiconductor films and values of x of MIIaₓ(O, OH, S) (where M represents Zn) are shown.

Table 2

| Experiment. No. | Added Amount of Group IIa Element Compound (atomic ratio) | Volume Resistivity (Ω·cm) | Open Circuit Voltage (V) | Short Circuit Current (mA/cm²) | Fill Factor | Energy Conversion Efficiency (%) |
|---|---|---|---|---|---|---|
| 9 | MgCl₂ 0.001 | 9×10⁹ | 0.63 | 34.8 | 0.66 | 14.5 |
| 10 | MgCl₂ 0.01 | 2×10⁹ | 0.62 | 33.6 | 0.64 | 13.3 |
| 11 | SrCl₂ 0.001 | 7×10⁹ | 0.63 | 34.5 | 0.65 | 14.1 |
| 12 | SrCl₂ 0.01 | 3×10⁹ | 0.63 | 33.8 | 0.63 | 13.4 |

As is clear from Table 2, the compound semiconductor films and the solar cells of the present example exhibited excellent outcomes.

### Example 5

Experiments were carried out by altering the component containing the metal element in Example 1. The experiments were carried out in the same manner as that for Example 1 except that tin chloride, cadmium chloride, indium chloride, or gallium chloride was used in place of zinc chloride (ZnCl₂). Values regarding compound semiconductor films and solar cells detected as a result of the experiments are shown in Table 3.

Table 3

| Experiment No. | Added Amount of Group IIa Element Compound (atomic ratio) | Volume Resistivity (Ω·cm) | Open Circuit Voltage (V) | Short Circuit Current (mA/cm²) | Fill Factor | Energy Conversion Efficiency (%) |
|---|---|---|---|---|---|---|
| 13 | tin chloride 0.005 | 6 × 10⁹ | 0.64 | 34.5 | 0.63 | 13.9 |
| 14 | cadmium chloride 0.005 | 4 × 10⁹ | 0.63 | 34.0 | 0.64 | 13.7 |
| 15 | indium chloride 0.005 | 6 × 10⁹ | 0.65 | 33.1 | 0.64 | 13.8 |
| 16 | gallium chloride 0.005 | 5 × 10⁹ | 0.65 | 34.2 | 0.64 | 14.2 |

As is clear from Table 3, the compound semiconductor films and the solar cells of the present example exhibited excellent outcomes.

### Industrial Applicability

The present invention can be utilized for improving properties of a solar cell, particularly its energy conversion efficiency

## Claims

1. A compound semiconductor film being a film of a semiconductor containing:
A. at least one element selected from zinc, tin, cadmium, indium, and gallium;
B. at least one element selected from oxygen and sulfur; and
C. an element of Group IIa.

2. The compound semiconductor film according to claim 1,
wherein the element of Group IIa is at least one element selected from magnesium, calcium, strontium, and barium.

3. The compound semiconductor film according to claim 1,
wherein the compound semiconductor is:
Zn(O, S):element of Group IIa;
Zn(O, OH, S):element of Group IIa;
Sn(O, OH, S):element of Group IIa;
Cd(O, OH, S):element of Group IIa;
CdZn(O, OH, S):element of Group IIa;
ZnSn (O, OH, S):element of Group IIa;
In(O, OH, S):element of Group IIa
Ga(O, OH, S):element of Group IIa;
InGa(O, OH, S):element of Group IIa
ZnGa(O, OH, S):element of Group IIa
ZnIn(O, OH, S):element of Group IIa;
CdS:element of Group IIa;
ZnS:element of Group IIa;
In₂S3:element of Group IIa;
Ga₂S₃:element of Group IIa;
In₂O₃:element of Group IIa; or
Ga₂O₃:element of Group IIa,
where bracketed symbols of the elements represent anion groups necessary for keeping charge neutrality with metal ions (ion groups), the charge neutrality being kept by metal ions (ion groups) and anions in the brackets.

4. The compound semiconductor film according to claim 1, having a volume resistivity of not less than 5×10⁸ Ω·cm and not more than 1×10¹¹ Ω·cm.

5. The compound semiconductor film according to claim 1, being expressed by a general formula of MIIaₓ(O, S) or MIIaₓ(O, OH, S),
where
M represents at least one element selected from zinc, tin, cadmium, indium, and gallium, and
x represents a value in a range of 0.0008 to 0.012.

6. The compound semiconductor film according to claim 1, having a film thickness in a range of not less than 10 nm and not more than 150 nm.

7. A method for producing a compound semiconductor film comprising the steps of:
preparing a material solution by dissolving in water a compound containing at least one selected from the group consisting of zinc, tin, cadmium, indium, and gallium, and a compound containing sulfur, and a Group IIa element compound containing an element of Group IIa; and
bringing the material solution prepared at a predetermined temperature into contact with a substrate so that a compound semiconductor film is deposited on the substrate, the compound semiconductor film containing:
A. at least one element selected from zinc, tin, cadmium, indium, and gallium;
B. at least one element selected from oxygen and sulfur; and
C. an element of Group IIa.

8. The method for producing a compound semiconductor film according to claim 7,
wherein as the Group IIa element compound, a chloride of an element of Group IIa, an iodide of an element of Group IIa, a bromide of an element of Group IIa, a nitrate of an element of Group IIa, a sulfate of an element of Group IIa, or an acetate of an element of Group IIa is used.

9. The method for producing a compound semiconductor film according to claim 7,
wherein in the step in which the compound semiconductor film is deposited, the material solution has a pH in a range of not less than 9 to not more than 11.

10. The method for producing a compound semiconductor film according to claim 7,
wherein in the step of preparing the material solution, the pH of the material solution is adjusted by dissolving ammonia additionally in the water.

11. The method for producing a compound semiconductor film according to claim 7,
wherein in the step of preparing the material solution, , the pH of the material solution is adjusted by dissolving an ammonium salt additionally in the water.

12. The method for producing a compound semiconductor film according to claim 11,
wherein in the step of preparing the material solution, at least one compound selected from the group consisting of ammonium acetate, ammonium chloride, ammonium iodide, and ammonium sulfate is used as the ammonium salt.

13. The method for producing a compound semiconductor film according to claim 7,
wherein in the step in which the compound semiconductor film is deposited, the predetermined temperature of the material solution is in a range of not lower than 10°C and not higher than 100°C.

14. The method for producing a compound semiconductor film according to claim 7,
wherein in the step in which the compound semiconductor film is deposited, the substrate is immersed in the material solution.

15. The method for producing a compound semiconductor film according to claim 7,
wherein in the step of preparing the material solution, at least one compound selected from the group consisting of acetates, chlorides, iodides, and sulfates is dissolved in the water as the compound containing a metal.

16. The method for producing a compound semiconductor film according to claim 7,
wherein in the step of preparing the material solution, at least one compound selected from the group consisting of thiourea and thioacetamide is dissolved in the water as the compound containing sulfur.

17. A solar cell comprising:
a substrate;
a conductive film;
a light-absorption layer;
a compound semiconductor film; and
a transparent conductive layer,
these being stacked in the stated order, or in the order of the substrate, the conductive film, the compound semiconductor film, the light-absorption layer, and the transparent conductive layer,
wherein the compound semiconductor film contains:
A. at least one element selected from zinc, tin, cadmium, indium, and gallium;
B. at least one element selected from oxygen and sulfur; and
C. an element of Group IIa.

18. The solar cell according to claim 17,
wherein the element of Group IIa is magnesium, calcium, strontium, or barium.

19. The solar cell according to claim 17,
wherein the compound semiconductor film is expressed by a general formula of MIIaₓ(O, S) or MIIaₓ(O, OH, S),
where
M represents at least one element selected from zinc, tin, cadmium, indium, and gallium, and
x represents a value in a range of 0.0008 to 0.012.

20. The solar cell according to claim 17,
wherein the compound semiconductor film has a film thickness in a range of not less than 10 nm and not more than 150 nm.

21. The solar cell according to claim 17,
wherein the light-absorption layer is formed with a compound semiconductor containing an element of Group Ib, an element of Group IIIa, and an element of Group VIa.

22. The solar cell according to claim 17,
wherein the compound semiconductor of the light-absorption layer contains:
Cu as the element of Group Ib;
at least one element selected from the group consisting of In and Ga as the element of Group IIIb; and
at least one element selected from the group consisting of Se and S as the element of Group VIb.

23. A method for producing a solar cell comprising the step of either:
stacking a substrate, a conductive film, a light-absorption layer, a compound semiconductor film, and a transparent conductive layer in the stated order; or
stacking a substrate, a conductive film, a compound semiconductor film, a light-absorption layer, and a transparent conductive layer in the stated order,
wherein the compound semiconductor film is formed by:
preparing a material solution by dissolving in water a compound containing at least one selected from zinc, tin, cadmium, indium, and gallium, a compound containing sulfur, and a Group IIa element compound containing an element of Group IIa; and
bringing the material solution prepared at a predetermined temperature into contact with at least the substrate so that a compound semiconductor film is deposited, the compound semiconductor film containing:
A. at least one element selected from zinc, tin, cadmium, indium, and gallium;
B. at least one element selected from oxygen and sulfur; and
C. an element of Group IIa.
